# EUROPEAN PATENT APPLICATION

(11) **EP 1 154 466 A1**
(43) Date of publication of application: **14.11.2001**
(21) Application number: 00901898.7
(22) Date of filing: 26.01.2000
(51) Int. Cl.: H01L 21/205

(54) **METHOD AND APPARATUS FOR PLASMA PROCESSING**

(30) Priority: 29.01.1999 JP 2112099
(71) Applicant: TOKYO ELECTRON LIMITED, Minato-ku, Tokyo 107-8481 (JP)
(72) Inventor: AMANO, Hideaki, Zama-shi Kanagawa 288-0002 (JP); ISHIZUKA, Shuichi, Nakakoma-gun Yamanashi 409-3867 (JP); KOBAYASHI, Takashi, Kofu-shi Yamanashi 400-0075 (JP); TSUBOI, Kyo, Sagamihara-shi Kanagawa 229-0002 (JP)
(74) Representative: Liesegang, Eva
(86) International application number: JP0000376
(87) International publication number: WO0045427

(57) **Abstract**

A temperature-adjusting means is buried in an upper portion of a ring member which surrounds a stage for a semiconductor wafer and has the same height as the stage. The temperature-adjusting means is controlled by the ring-member temperature controller 61, according to a recipe for setting a process condition, in such a manner that temperatures of a surface of the wafer and of an upper surface of the ring member are even, respectively. At that time, a temperature difference between above the wafer and above the upper surface of the ring member is made small, which enables to form a film having a higher uniformity.

## Description

### FIELD OF THE INVENTION

This invention relates to a plasma processing unit and a plasma processing method, for conducting a process such as a film deposition or an etching by means of plasma for example to a semiconductor wafer.

### BACKGROUND OF THE INVENTION

In general, in steps for manufacturing semiconductor devices, there is a process such as a film deposition or an etching to a semiconductor wafer (hereafter, which is abbreviated as a wafer) by means of plasma. The process is conducted by introducing a process gas into a vacuum container including a stage for the wafer and by supplying for example electromagnetic energy to the process gas in order to make the process gas into plasma. As a method of supplying the electromagnetic energy, there are known a method of utilizing an electron cyclotron resonance (ECR) i.e. an interaction between a microwave and a magnetic field, and a method called ICP (Inductive Coupled Plasma) wherein a coil wound around a dome-like container gives an electric field and a magnetic field to a process gas.

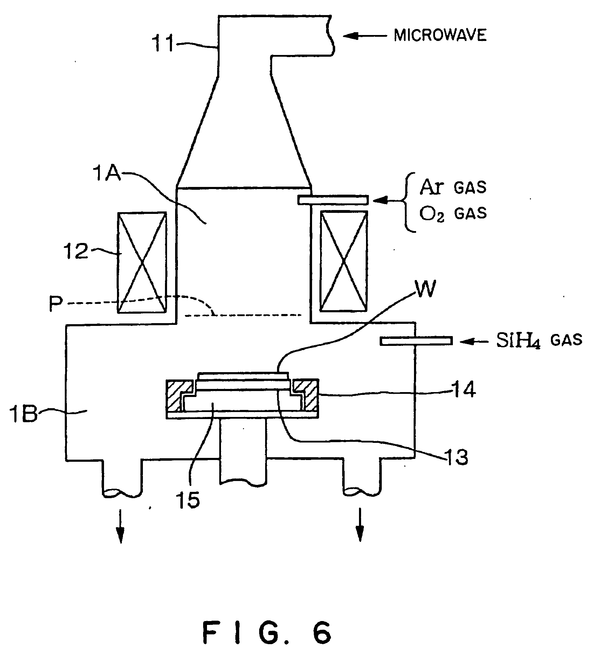

With reference to Fig.6, an example of conventional plasma film deposition unit for conducting an ECR plasma film deposition process is explained. A predetermined high-frequency wave such as a microwave of 2.45 GHz is introduced into a first vacuum chamber 1A through a wave guide 11. At the same time, an electromagnetic coil 12 is impressed such a voltage that strength of a magnetic field at a dotted-line position P shown in Fig.6 is for example 875 gauss. A plasma-generating gas such as Ar gas and/or O₂ gas is densely made into plasma by means of an interaction (resonance) between the microwave and the magnetic field. The plasma activates for example SiH₄ gas, which is introduced into a second vacuum chamber 1B, to produce activated species. Then, a film is formed on a surface of a semiconductor wafer W placed on a stage 13 which consists of a dielectric.

A cooling jacket 15, which is maintained at about a room temperature, is provided in an under portion of the stage 13 in order to adjust a temperature of the wafer W to a predetermined process temperature by absorbing heat from the wafer W whose temperature has been raised by radiant heat from the plasma and/or ion-incidence while the plasma is generated. The temperature of the cooling jacket 15 is so low that the activated species tend to be stuck thereto and form a thin film thereon. Thus, in order to prevent the thin film from being formed thereon, a ring member 14 is provided in such a manner that the ring member 14 surrounds the stage 13 and that an upper surface of the ring member 14 is located nearby a level of a placing-surface of the stage 13. The ring member 14 is made of for example alumina.

For example, when a film such as SiO₂ film is formed by the above unit, the wafer W is heated to a predetermined temperature such as about 300°C in order to conduct a film deposition process. However, dependently on plasma-process conditions, there is a phenomenon that a thickness of the film deposited on the wafer W may be larger in a peripheral portion (a portion near an edge thereof) and smaller in a central portion.

As described above, the film deposition process by using the plasma process is conducted by an accumulation of the activated species (neutral particles or ions, for example radicals), which have been activated by the plasma. Behavior of the activated species on and above a surface of a substrate such as a wafer W depends on a temperature of the surface. For example, time for which the activated species stay on the surface of the substrate may be different. That is, if the temperature of the surface is relatively high, time for which the activated species stay on the wafer W may be shortened. This decreases a deposition rate per unit time in the film deposition process. Such a behavior of the activated species may happen not only on the surface of the wafer W but also on the surface of the ring member 14.

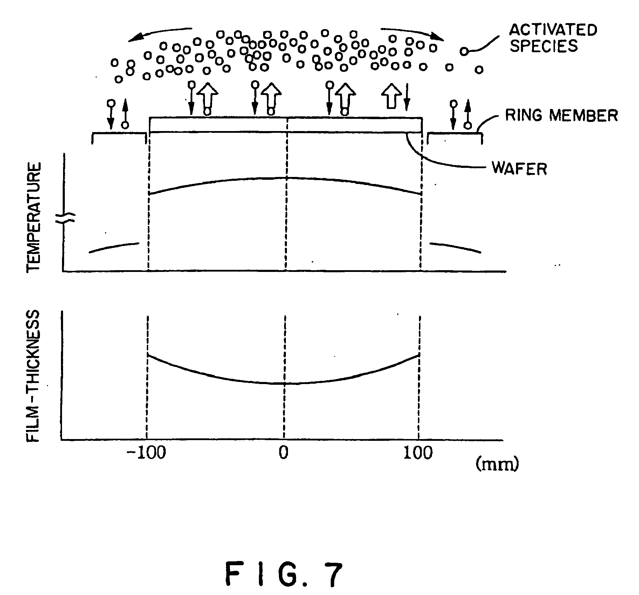

As described above, the temperature of the wafer W is adjusted by taking into consideration that the wafer W is heated while the plasma is generated. However, there is no consideration for the ring member 14. Thus, dependently on the plasma-process conditions, the temperature of the ring member 14 may be higher or lower than that of the wafer W. Thus, there is a phenomenon that the behavior of the activated species on the surface of the wafer W may be different from that on the surface of the ring member 14. That is, if the temperature of the ring member 14 is lower than that of the surface of the wafer W, a ratio of the activated species being not accumulated on the surface of the wafer W and away from the wafer W is larger than a ratio of the activated species being not accumulated on the surface of the ring member 14 and away from the ring member 14. Thus, as shown in Fig.7, it is thought that the activated species move from on and/or above the surface of the wafer W to on and/or above the ring member 14. Thus, it is thought that this results in uneven distribution of the thickness of the film.

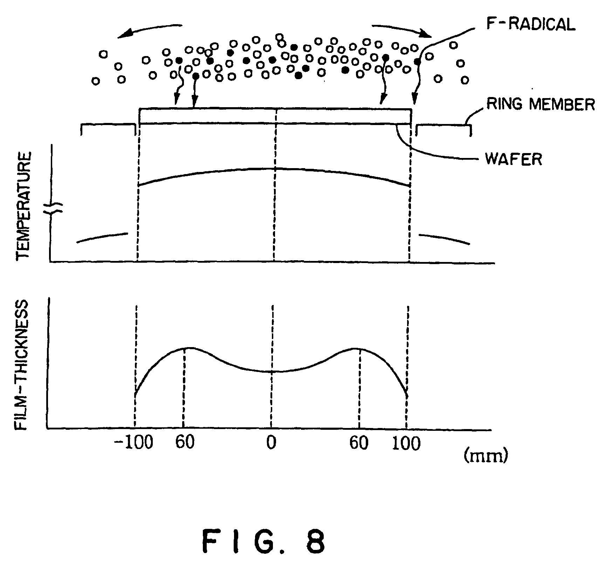

In addition, if a predetermined plasma process wherein a gas including F is used, such as a film deposition process of a CF film, is conducted by using the same unit, dependently on the plasma-process conditions, the film may have a thickness whose distribution is shown in Fig.8. In the case as well, it is thought that a moving (diffusion) phenomenon of the activated species may happen in the same way as described above. In addition, an activated seed of F such as F-radical has a very strong etching-effect. Thus, the F-radical etches a peripheral portion of the wafer when the F-radical diffuses from a central portion of the wafer to the ring member, which reduces the thickness of the peripheral portion of the wafer. It is worried about that such a phenomenon may very much affect the movement of increasing a size of the wafer W and/or the movement of further reducing a thickness of the thin film.

### SUMMARY OF THE INVENTION

This invention is intended to solve the above problem. The object of this invention is to provide a plasma processing unit and a plasma processing method which can conduct a plasma process with high uniformity in a surface of a substrate when the plasma process such as a film deposition or an etching is conducted on the substrate.

In order to achieve the object, an invention is a plasma processing unit having a stage on which a substrate is placed, adapted to generate a plasma and conduct a predetermined process to the substrate placed on the stage by means of the plasma, comprising: a ring member provided in such a manner that the ring member surrounds the stage and that a level of an upper surface of the ring member is located nearby a placing-surface of the stage; a means that stores a plasma-process condition for conducting the predetermined process; a means that sets a temperature condition for the ring member, based on the plasma-process condition; and a first temperature-adjusting means that adjusts a temperature of the ring member, based on the temperature condition for the ring member.

The first temperature-adjusting means may be arranged in the ring member. Alternatively, the first temperature-adjusting means may be arranged in the stage. In addition, a protecting member may be provided on the upper surface of the ring member.

Preferably, the plasma processing unit further comprises: a temperature-measuring means that measures a temperature of the substrate and/or a temperature of the ring member; and a controlling means that controls the first temperature-adjusting means, based on the temperature condition for the ring member and information from the temperature-measuring means. In the case, further preferably, the plasma processing unit further comprises a second temperature-adjusting means that adjusts a temperature of the stage, and the controlling means is adapted to control the second temperature-adjusting means as well.

Preferably, the plasma-process condition may include at least a condition for generating a magnetic field in the processing unit.

In addition, an invention is a plasma processing method for generating a plasma and conducting a film deposition or etching process to a substrate placed on a stage by means of the plasma, comprising: a step of setting a plasma-process condition for conducting the film deposition or etching process; a step of heating at least a ring member to a predetermined temperature determined based on the plasma-process condition before the film deposition or etching process is conducted, the ring member being provided in such a manner that the ring member surrounds the stage and that a level of an upper surface of the ring member is located nearby a placing-surface of the stage; and a step of conducting the film deposition or etching process to the substrate, based on the plasma-process condition.

In the case, the step of heating the ring member may be conducted by using a plasma.

Preferably, the plasma processing method further comprises a step of adjusting the ring member to a temperature lower than the predetermined temperature, before the step of heating the ring member.

### BRIEF DESCRIPTION OF THE DRAWINGS

Fig.1 is a vertical sectional view for showing a whole structure of a plasma film deposition unit according to a first embodiment of the invention;
Fig.2 is a schematic sectional view of a portion around a stage shown in Fig.1;
Fig.3 is a schematic sectional view of a portion around a stage of a plasma film deposition unit according to a second embodiment of the invention;
Fig.4 is a schematic sectional view of a portion around a stage of a plasma film deposition unit according to a third embodiment of the invention;
Fig.5 is a schematic sectional view of a portion around a stage of a plasma film deposition unit according to a fourth embodiment of the invention;
Fig.6 is a vertical sectional view for showing a conventional plasma film deposition unit;
Fig.7 is views for explaining a moving state of film deposition species not including F and a film deposition state, above and on a stage in a conventional plasma process; and
Fig.8 is views for explaining a moving state of film deposition species including F and a film deposition state, above and on a stage in a conventional plasma process.

### DESCRIPTION OF THE PREFERRED EMBODIMENT

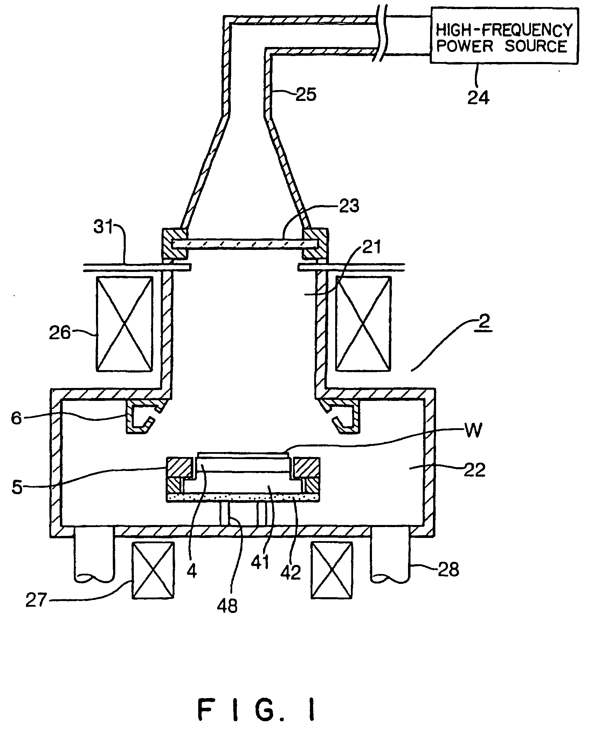

Fig.1 is a view for showing a plasma film deposition unit according to a first embodiment of the invention. As shown in Fig.1, the plasma film deposition unit includes a vacuum container 2 made of for example aluminum or the like. The vacuum container 2 includes a first cylindrical vacuum chamber 21 located in an upper portion thereof for generating plasma, and a second cylindrical vacuum chamber 22 having a diameter larger than that of the first vacuum chamber 21. The second vacuum chamber 22 is arranged under and connected to the first vacuum chamber 21. In addition, the vacuum container 2 is grounded to be in zero potential.

An upper end of the vacuum container 2 has an opening. A penetrable window 23 made of a microwave penetrable material such as a crystal is sealingly fitted in the opening. Thus, an inside of the vacuum container 2 can be maintained at a vacuum. A wave guide 25 is provided outside of the penetrable window 23. The wave guide 25 is connected to a high-frequency power source 24, which can generate a microwave of for example 2.45 GHz. Then, the microwave generated by the high-frequency power source 24 is introduced via the wave guide 25 by for example a TE mode. Alternatively, the microwave guided by the TE mode is converted to a TM mode in the wave guide 25, and the converted microwave can be introduced into the first vacuum chamber 21 through the penetrable window 23.

A plurality of gas nozzles 31 are arranged around a side wall defining the first vacuum chamber 21, for example at regular intervals in a peripheral direction thereof. The plurality of gas nozzles 31 are connected to a gas source such as a plasma-generating gas source not shown. Thus, a plasma-generating gas such as Ar gas can be uniformly supplied into an upper portion of the first vacuum chamber 21.

A wafer-stage 4 having a substantially same size as a wafer W is arranged in the second vacuum chamber 22 to face the first vacuum chamber 21. A ring member 5 is arranged to surround an outside peripheral surface of the wafer-stage 4. The wafer-stage 4 and the ring member 5 are supported by a supporting portion 48 via an insulator 42 which is made of for example alumina.

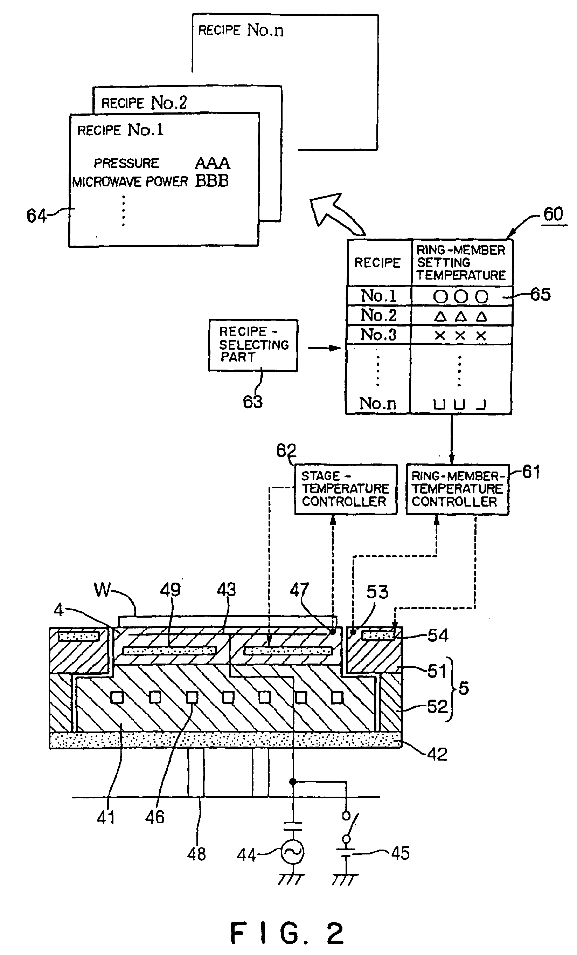

As shown in Fig.2, the stage 4 is formed in such a manner that an electrode 43 both for applying bias potential and for serving as an electrostatic chuck is provided in a surface portion of an insulator such as AlN (aluminum nitride) and that a temperature-adjusting means 49 such as a resistance heater is arranged in an inside portion of the insulator. A cooling jacket 41 made of for example aluminum and having cooling-medium paths 46 therein is arranged in a lower portion of the stage 4. Acooling medium of for example 25°C such as water is supplied into the cooling-medium paths 46. Thus, the cooling jacket 41 can be maintained at a predetermined temperature.

The electrode 43 is connected to a high-frequency power source 44 for applying a bias potential to draw ions up to the wafer W and to a direct-current power source 45 for electrostatically sticking to the wafer W.

The ring member 5 is arranged in such a manner that the ring member 5 surrounds the periphery of the stage 4 while spacing by a slight gap and that a level of an upper surface of the ring member 5 is located nearby a placing-surface of the stage 4. The ring member may be assembled from a plurality of parts such as an upper ring part 51 and a lower ring part 52, in order to prevent heat from going away downward. The ring member 5 is adapted to prevent a film from being formed on the outside periphery surface of the stage 4. A material for the ring member 5 may be preferably alumina (Al₂O₃) or aluminum nitride (AlN), which tend not to be etched. It may be Al if the thermal response is taken into consideration. In addition, in the embodiment, as shown in Fig.2, a temperature-adjusting means 54 consisting of for example a resistance heater, which may function as a first temperature-adjusting means, is buried in an upper surface portion of the ring member 5.

A temperature detector 47 consisting of a thermo-couple, which is a temperature measuring means, is inserted into a portion near the placing surface of the stage 4. Similarly, a temperature detector 53 consisting of a thermo-couple, which functions as a temperature measuring means, is provided in the upper surface portion of the ring member 5. Thus, by means of the temperature detectors 47 and 53, a temperature of the upper surface of the wafer W and a temperature of the upper surface of the ring member 5 can be measured, respectively. In addition, the temperature detectors 47 and 53 may be radiation thermometers.

A detection temperature that is measured by the temperature detector 47 is inputted as a feed-back signal to a stage-temperature controller 62 which is a controlling means. The stage-temperature controller 62 controls a heating volume of the temperature-adjusting means 49 and/or a supplying rate of a backside gas, via a electric-power supplying part and a backside-gas supplying part not shown, in order to maintain the temperature of the surface of the wafer W at a predetermined film deposition temperature. In addition, as a method to control the temperature of the wafer W, a temperature of the cooling medium that flows in the cooling-medium paths 46 can be adjusted. In the case, the temperature-adjusting means 49, the backside gas and the cooling medium serve as a second temperature-adjusting means.

A detection temperature that is detected by the temperature detector 53 is inputted as a feed-back signal to a ring-member-temperature controller 61 which is a controlling means. The ring-member-temperature controller 61 can adjust a heating volume of the temperature-adjusting means 54 via a electric-power supplying part not shown, based on the detection temperature and set temperature described below. The temperature of the ring member 5 is determined in advance for example based on results of experiments and/or simulations.

In Fig.2, 60 represents a storing part 60. The storing part 60 stores a plurality of recipes 64 for setting process conditions. The process condition means factors affecting plasma density and/or distribution of the plasma density that decide a state of the process. For example, the factors may be a pressure in the vacuum container 2, a microwave power from the high-frequency power source 24, a shape of the magnetic field (excitation currents in a main electromagnetic coil 26 and an auxiliary electromagnetic coil 27 described below), a flow rate of a process gas, a flow rate of a backside gas and/or a temperature of the wafer W. For example, a set of the factors is described in each of the recipes 64. In the case, the process condition may be a predetermined condition. Alternatively, in order to conduct processes suitably, the process condition may be set for each of the processes, for example for each of lots of the wafers.

In the embodiment, the temperature of the upper surface of the ring member 5 is adjusted according to a state of the plasma. A set temperature 65 for a unit (the upper surface of the ring member 5) is stored in the storing part 60 correspondingly to each of the recipes. 63 represents a recipe-selecting part consisting of for example a touch panel or a keyboard. When one recipe is selected by means of the recipe-selecting part 63, a corresponding set temperature 65 of the ring member is also selected. Then, the unit is driven and controlled based on the selected data.

As shown in Fig.1, a circular film-deposition-gas supplying member 6 is provided at an upper portion of the second vacuum chamber 22, that is, at a connecting portion of the second vacuum chamber 22 and the first vacuum chamber 21. The film-deposition-gas supplying member 6 is adapted to jet out a film deposition gas, which is supplied from gas-supplying tubes not shown thereinto, into the vacuum chamber 22. In addition, exhausting pipes 28 are connected to a base plate of the vacuum chamber 22, for example at two positions symmetric with respect to a central axis of the vacuum chamber 22.

A magnetic-field forming means such as a circular main electromagnetic coil 26 is arranged around and near to the side wall defining the first vacuum chamber 21. A circular auxiliary electromagnetic coil 27 is arranged below and near to the second vacuum chamber 22.

Then, a method for forming an interlayer dielectric film consisting of for example an SiO₂ film onto a wafer W as a substrate by using the above unit is explained with reference to Figs.1 and 2.

At first, a gate valve (not shown) provided at a side wall of the vacuum container 2 is opened. A conveying arm (not shown) conveys the wafer W as a substrate from a load-lock chamber (not shown) onto the stage 4 via the gate valve. Then, a direct-current potential is applied to the electrode 43 so that the wafer W conveyed onto the stage 4 is electrostatically adhered to the stage 4.

Then, the gate valve is closed, and the inside of the vacuum container 2 is hermetically closed. Then, gas of the inside of the vacuum container 2 is exhausted from the exhausting pipes 28, so that the inside of the vacuum container 2 is produced to a predetermined vacuum. In such a state, one or more plasma-generating gases such as Ar gas and O₂ gas is introduced into the first vacuum chamber 21 through the plasma-gas nozzles 31.

The high-frequency wave (microwave) of 2.45 GHz from the high-frequency power source 24 is introduced into the first vacuum chamber 21 through the wave guide 25 and through the penetrable window 23 at the ceiling of the vacuum container 2. In the vacuum container 2, the electromagnetic coils 26 and 27 form a magnetic field in a direction from an upper portion of the first vacuum chamber 21 toward a lower portion of the second vacuum chamber 22. For example, a strength of the magnetic field at a lower portion of the first vacuum chamber 21 is 875 gauss.

An electric cyclotron resonance is generated by an interaction between the magnetic field and the microwave. The resonance causes the Ar gas to become plasma and to be much dense. Since the plasma is made of Ar gas, the plasma is much stable.

The wafer W is, so to speak, preheated by the Ar plasma to for example about 350°C, dependently on balance of a heat-absorbing volume thereof and a heat-radiation volume toward the cooling jacket 41. Such a heating control is conducting by introducing a backside gas such as He gas into a gap between the wafer W and the stage 4 and/or into a gas groove provided at the placing-surface of the stage 4, and by adjusting a pressure of the gas in order to adjust a heat-radiation volume radiated from the wafer W to the stage 4. In addition to adjusting the pressure of the gas, temperature adjustment by the temperature-adjusting means 49 or temperature adjustment by the cooling medium flowing in the cooling-medium paths 46 may be conducted.

On the other hand, the ring member 5 is also heated by the plasma. Plasma density above the ring member 5 is substantially the same as plasma density above the wafer W at an area near above the wafer W. However, the plasma density is lower at an area further from above the wafer W. Thus, as a result, the ring member 5 is heated to a temperature lower than the temperature of the wafer W, for example to about 250°C. Then, the temperature-adjusting means 54 in the ring member 5 generates a heat in order to raise the temperature of the ring member 5 to a set temperature. In addition, before the ring member 5 is preheated by the plasma, the ring member 5 may be heated to for example about 80°C by the temperature-adjusting means 54 in advance. In the case, time for which the ring member 5 is heated to the set temperature can be shortened. In addition, before the film deposition process, the wafer may be heated to the predetermined temperature and the ring member 5 may be preheated by controlling the magnetic field.

Heat of the ring member 5 may flow toward the cooling jacket 41. However, the temperature near the upper surface of the ring member 5 can be controlled by the ring-member-temperature controller 61, as described above. That is, the temperature-adjusting means 54 conducts a temperature control dependently on the state of the plasma, which is determined by a selected recipe, in such a manner that a temperature of the plasma is even from above the wafer W to the outside.

Then, the inside of the vacuum container 2 is maintained at a predetermined process pressure, and a film deposition gas such as SiH₄ gas is introduced from the film-deposition-gas supplying member 5 into the second vacuum chamber 22 at a predetermined flow rate. At the same time, a bias voltage of 13.56 MHz and 1500 W is applied to the stage 4 by the high-frequency power source 44.

The plasma flows from the first vacuum chamber 21 into the second vacuum chamber 22 and activates the SiH₄ gas, which is supplied thereinto, to produce activated species. Thus, a SiO₂ film is formed on the wafer W.

According to the embodiment, since the surface temperatures of the wafer W and the ring member 5 are even, an attachment coefficient of the activated species in the plasma to the wafer W is equal to that to the ring member 5. As a result, a difference between times of their stays becomes small. In addition, a difference of temperatures between temperatures of spaces above the wafer W and above the ring member 5 becomes small as well. As a result, it is prevented that the activated species diffuse toward above the ring member 5. Thus, a density of the activated species above the peripheral portion of the wafer W becomes equal to a density of the activated species above the central portion of the wafer W. Then, an accumulated volume of the film deposition species becomes uniform. Thus, it may be prevented that a thickness of the film deposited on the wafer W becomes larger in the peripheral portion and smaller in the central portion like the conventional example explained with reference to Fig.7. That is, uniformity of the thickness of the film within the wafer may be improved.

If the ring member 5 is preheated by using the plasma heat, smaller exothermic energy from the temperature adjusting means 54 may be sufficient. Furthermore, in the case, if the ring member 5 is heated in advance to for example 80°C by the temperature adjusting means 54, time for preheating the ring member 5 by means of the plasma after that may be shortened. A material for the ring member 5 is not limited. However, if the material is a metal such as Al, efficiency of the heating may be high, and throughput may be improved.

The invention is not limited by the above case wherein the temperatures of the wafer W and the ring member 5 are made even. For example, dependently on each of the recipes, the surface temperature of the ring member 5 may be made higher than the surface temperature of the wafer W and distribution of the plasma density from the area above the ring member 5 toward above the central area of the wafer W may be controlled to a desired distribution, in order to improve the uniformity of the process. Thus, a set temperature of the ring member 5 corresponding to a recipe may be determined by finding out a suitable condition for the recipe in advance. For example, the set temperature may be determined dependently on the plasma density, the surface temperature of the wafer W or the like.

A concrete example is explained about a selected recipe and the set temperature of the ring member 5. For example, in a case of using the ECR unit, there is a magnetic profile as a factor affected by the distribution of the plasma density. If a vertical sectional profile of an iso-magnetic-distribution plane that is an ECR point (see dotted line in Fig.6) is upwardly convex, a temperature of a peripheral portion of the plasma may become lower than that of a central portion thereof. Thus, preferably, the temperature of the ring member 5 may be set to be higher than the temperature of the wafer W in order to compensate the above temperature difference. In addition, if a vertical sectional profile of the even-magnetic-distribution plane is downwardly convex, the temperature of the ring member 5 may be preferably set to be lower than the temperature of the wafer W.

In the invention, the temperature of the ring member 5 may be adjusted, based on a temperature condition of the ring member 5 and both measured values of the temperature of the ring member 5 and the temperature of the wafer W. Alternatively, the temperature of the ring member 5 may be adjusted, based on a temperature condition of the ring member 5 and a measured value of the temperature of the wafer W. In addition, the temperature of the stage 4 may be adjusted, based on both measured values of the temperature of the wafer W and the temperature of the ring member 5. Alternatively, the temperature of the stage 4 may be adjusted, based on a measured value of the temperature of the ring member 5.

The invention is effective in a process wherein F-radicals are generated and a film is formed by a balance of accumulation of activated species and etching effect of the F-radical, for example in a case of forming a SiOF film or in a case of forming a CF film (fluorine-added carbon film) by using C₆F₆ as a process gas, because densities of the activated species and the F-radicals above the ring member 5 and the wafer W may be controlled.

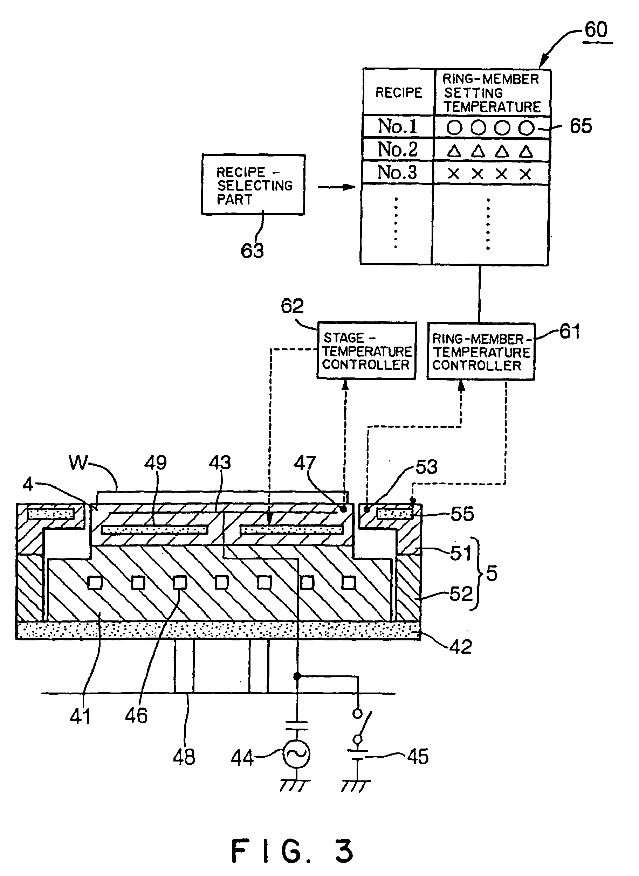

A method for adjusting the temperature for improving the uniformity of the film-thickness as described above may be also achieved by a second embodiment shown in Fig.3. In the second embodiment, as shown in Fig.3, a lower inside portion of the upper ring part 51 of the ring member 5 (a portion opposite to an upper peripheral surface of the cooling jacket 41 of the stage 4) is dented to form a large gap. Thus, a heat-radiation volume from the ring member 5 to the cooling jacket 41 may become smaller. Although not shown, a thermal insulating member may be inserted into the gap in order to reduce the heat-radiation from the ring member 5 to the cooling jacket 41. According to the structure, the ring member 5 may tend not to be cooled by the cooling jacket 41, so that energy necessary for heating may be reduced.

In addition, the level of the upper surface of the ring member 5 located nearby the placing-surface of the stage includes a case wherein the level is substantially the same as the level of the upper surface of the stage 4 and a case wherein the level is substantially the same as the level of the upper surface of the wafer W.

In addition, in the second embodiment shown in Fig.3, the radiation volume of the heat from the ring member 5 to the cooling jacket 41 is smaller. Thus, the temperature of the upper surface of the ring member 5 may be higher than the temperature of the wafer W. Thus, the temperature-adjusting means 55 is preferably a temperature-adjusting means capable to both heat and cool.

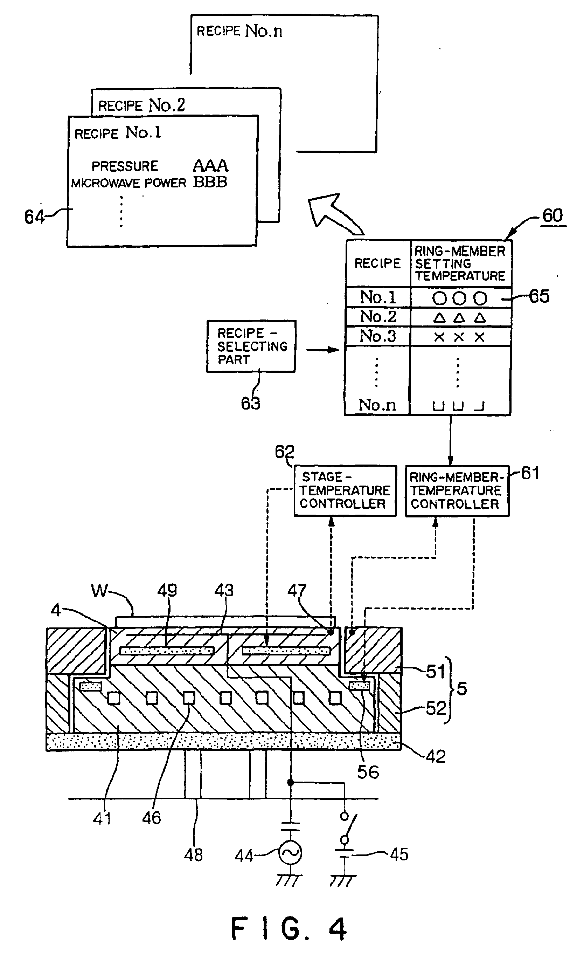

In a third embodiment shown in Fig.4, a temperature-adjusting means 56 functioning as a first temperature-adjusting means is arranged in the stage 4, instead of in the ring member 5. Other structure is substantially the same as the first embodiment. In the case, the ring member 5 may be controlled to a desired temperature as well.

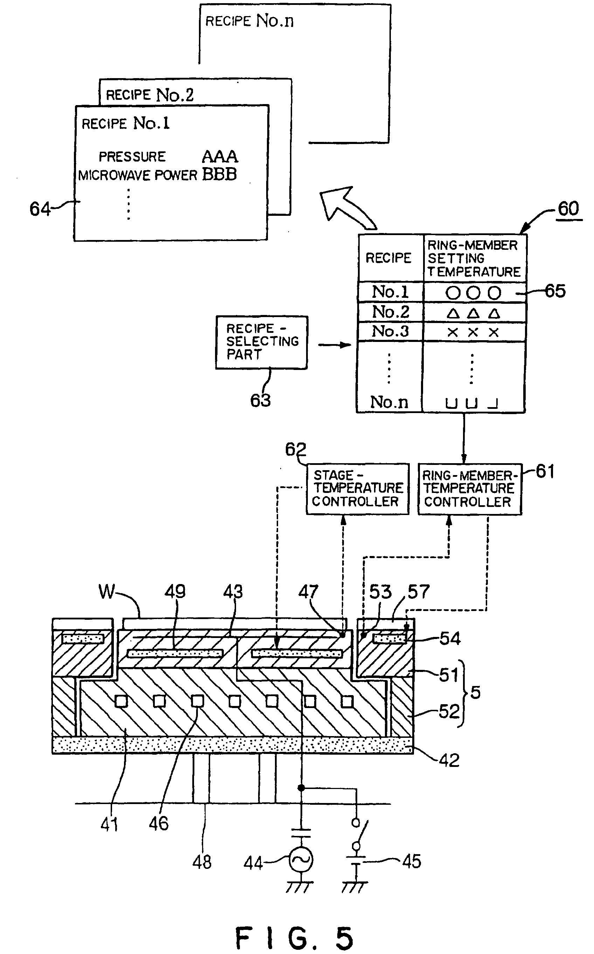

In a fourth embodiment shown in Fig.5, a protecting member 57 is arranged on the upper surface of the ring member 5. Other structure is substantially the same as the first embodiment. In the case, a lifetime of the ring member 5 may be extremely extended. As a material of the protecting member 57, Si, Al, Al₂O₃, AlN or the like may be used.

In the above embodiments, the electron cyclotron resonance is explained as an example of plasma generating means in the film deposition process. However, the plasma generating means in the film deposition process is not limited by the manner. For example, if a unit of magnetron discharge or ICP is used, a most suitable profile for generating objective plasma may be described as a recipe 64. If a unit with parallel-plates is used, a profile of a high-frequency power or the like may be described as a recipe 64 as well. In addition, the plasma process is not limited by the film deposition process explained in the above embodiments. For example, the invention is applicable to an etching process.

As described above, according to the invention, a plasma process may be conducted with higher uniformity within a surface, which may raise yield.

## Claims

1. A plasma processing unit having a stage on which a substrate is placed, adapted to generate a plasma and conduct a predetermined process to the substrate placed on the stage by means of the plasma, comprising;
a ring member provided in such a manner that the ring member surrounds the stage and that a level of an upper surface of the ring member is located nearby a placing-surface of the stage,
a means that stores a plasma-process condition for conducting the predetermined process,
a means that sets a temperature condition for the ring member, based on the plasma-process condition, and
a first temperature-adjusting means that adjusts a temperature of the ring member, based on the temperature condition for the ring member.

2. A plasma processing unit according to claim 1, wherein:
the first temperature-adjusting means is arranged in the ring member.

3. A plasma processing unit according to claim 2, wherein:
the first temperature-adjusting means is arranged in the stage.

4. A plasma processing unit according to claim 1, wherein:
a protecting member is provided on the upper surface of the ring member.

5. A plasma processing unit according to claim 1, further comprising:
a temperature-measuring means that measures a temperature of the substrate and/or a temperature of the ring member, and
a controlling means that controls the first temperature-adjusting means, based on the temperature condition for the ring member and information from the temperature-measuring means.

6. A plasma processing unit according to claim 5, further comprising:
a second temperature-adjusting means that adjusts a temperature of the stage,
wherein:
the controlling means is adapted to control the second temperature-adjusting means as well.

7. A plasma processing unit according to claim 1, wherein:
the plasma-process condition includes at least a condition for generating a magnetic field in the processing unit.

8. A plasma processing method for generating a plasma and conducting a film deposition or etching process to a substrate placed on a stage by means of the plasma, comprising;
a step of setting a plasma-process condition for conducting the film deposition or etching process,
a step of heating at least a ring member to a predetermined temperature determined based on the plasma-process condition before the film deposition or etching process is conducted, the ring member being provided in such a manner that the ring member surrounds the stage and that a level of an upper surface of the ring member is located nearby a placing-surface of the stage, and
a step of conducting the film deposition or etching process to the substrate, based on the plasma-process condition.

9. A plasma processing method according to claim 8, wherein:
the step of heating the ring member is conducted by using a plasma.

10. A plasma processing method according to claim 8, further comprising:
a step of adjusting the ring member to a temperature lower than the predetermined temperature, before the step of heating the ring member.
